(19) **Europäisches Patentamt**
**European Patent Office**
**Office européen des brevets**

(11) **EP 4 700 404 A1**

(12) **EUROPEAN PATENT APPLICATION**
published in accordance with Art. 153(4) EPC

(43) Date of publication:
**25.02.2026 Bulletin 2026/09**

(21) Application number: **25800682.4**

(22) Date of filing: **29.04.2025**

(51) International Patent Classification (IPC):
**G01R 31/367** (2019.01)    **G01R 31/392** (2019.01)
**G01R 31/382** (2019.01)

(52) Cooperative Patent Classification (CPC):
**Y02E 60/10**

(86) International application number:
**PCT/CN2025/092014**

(87) International publication number:
**WO 2025/241857 (27.11.2025 Gazette 2025/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **24.05.2024 CN 202410649213**

(71) Applicant: **Lbatterycloud Co. Ltd.**
**Yantai, Shandong 264000 (CN)**

(72) Inventors:
• **CI, Song**
**Yantai, Shandong 264000 (CN)**
• **ZHANG, Ming**
**Yantai, Shandong 264000 (CN)**
• **LI, Kai**
**Yantai, Shandong 264000 (CN)**
• **LI, Xuefeng**
**Yantai, Shandong 264000 (CN)**
• **WANG, Yunfang**
**Yantai, Shandong 264000 (CN)**
• **LI, Chaofan**
**Yantai, Shandong 264000 (CN)**
• **BAI, Xuheng**
**Yantai, Shandong 264000 (CN)**

(74) Representative: **Chung, Hoi Kan**
**Mandarin IP Limited**
**7 Cherry Trees**
**Great Shelford**
**Cambridge CB22 5XA (GB)**

(54) **BATTERY AGING EVALUATION METHOD BASED ON MULTI-SOURCE MULTI-SCALE HIGH-DIMENSIONAL STATE SPACE MODELING**

(57) Disclosed is a battery aging assessment method based on multi-source and multi-scale high-dimensional state space modeling in the field of energy storage in renewable power systems. The method includes: acquiring a time series of each discharge process within a preset number of discharge cycles of a sample battery; determining a first state transition path and a second state transition path based on discharge parameters corresponding to the time series; establishing a benchmark working-state transition path; calculating multiple sample distances between the second state transition path and the benchmark working-state transition path; training a battery aging assessment model using the sample distances as input and corresponding target state-of-health values as output; calculating a target distance between a state transition path of a to-be-predicted target battery and the benchmark working-state transition path; and inputting the target distance into the battery aging assessment model to obtain an SOH value of the to-be-predicted target battery. This disclosure can improve the accuracy of battery aging prediction.

**EP 4 700 404 A1**

S1 — Acquire a time series of each discharge process within a preset number of discharge cycles of a sample battery

S2 — Determine a state transition path of the sample battery's working state during each discharge process within the preset number of discharge cycles based on discharge parameters corresponding to the time series

S3 — Determine a benchmark working-state transition path based on a first state transition path of the sample battery's working state during each discharge process within the first preset number of discharge cycles

S4 — Calculate a distance between a second state transition path of the sample battery's working state during each discharge process within the second preset number of discharge cycles and the benchmark working-state transition path to obtain multiple sample distances

S5 — Acquire a target SOH value of the sample battery during each discharge process within the second preset number of discharge cycles

S6 — Train a neural network using the sample distances as input and the corresponding target SOH values as output to obtain a battery aging assessment model

S7 — Calculate a distance between a state transition path of a to-be-predicted target battery after a discharge process and the benchmark working-state transition path to obtain a target distance

S8 — Input the target distance into the battery aging assessment model to obtain an SOH value of the to-be-predicted target battery after completing a preset target number of discharge cycles

FIG. 1

**Description**

TECHNICAL FIELD

This disclosure relates to the technical field of energy storage in renewable power systems, and in particular, to a battery aging assessment method based on multi-source and multi-scale high-dimensional state space modeling.

BACKGROUND

Battery aging prediction refers to predicting performance degradation of a battery through mathematical modeling and experimental data analysis, encompassing various aspects such as capacity fading, internal resistance increase, and cycle life of the battery. Below are common battery aging prediction models and related industry advancements:

physics-based models: these models employ electrochemical principles and physical equations to describe chemical reactions and transport processes within a battery for aging behavior prediction. While providing deep insights into internal processes of the battery, they typically require complex mathematical formulations and extensive parameterization;

statistics-based models: by analyzing a large amount of experimental data, these models establish statistical correlations to predict aging behaviors of a battery. Though generally data-driven and requiring no deep insights into internal processes of the battery, they may have limited predictive capability for intricate aging mechanisms;

deep learning models: in recent years, deep learning technology has also made some progress in battery aging prediction. Deep learning models can learn complex nonlinear relationships from a large amount of data, showing certain potential for battery aging prediction. For example, models such as recurrent neural networks (e.g., LSTM) can be used for time series data forecasting; and

multi-physics coupling models: in recent years, an increasing number of studies have begun to explore multi-physics coupling models, integrating electrochemical, thermal, and mechanical models to more comprehensively describe complex interactions inside a battery and enable more accurate aging prediction.

The physics-based and multi-physics coupling models mentioned above require numerous hard-to-measure parameters for modeling, involve complex computational processes, and incur high computational costs, making them challenging to apply in real-world scenarios. Machine learning models, such as those based on deep learning, employ black-box modeling approaches, resulting in poor interpretability and transferability. Additionally, due to battery-specific characteristics, diverse operating conditions, and scarce fault samples, training neural networks with large data samples for prediction often yields results with significant errors. Statistical model-based methods typically rely solely on mathematical analysis without considering the physical mechanisms underlying battery aging.

From a modeling perspective, equivalent circuit models ignore influencing factors from various external environmental changes; SOX indicator systems provide only basic performance metrics, failing to characterize granular lifecycle evolution or analyze battery aging and fault modes (e.g., sudden state transitions), nor can they directly link to dynamically reconfigurable operating modes; in addition, they rely solely on time-domain data while neglecting features from other domains like a frequency domain. Although electrochemical models employ differential equations to simulate battery operation processes, their parameters prove difficult to measure and update, making direct practical application challenging.

SUMMARY

This disclosure is intended to provide a battery aging assessment method based on multi-source and multi-scale high-dimensional state space modeling, which can improve the accuracy of battery aging prediction.

To achieve the above objective, this disclosure provides the following solution:
a battery aging assessment method based on multi-source and multi-scale high-dimensional state space modeling, including:

acquiring a time series of each discharge process within a preset number of discharge cycles of a sample battery, where the time series includes a voltage time series and a current time series, and the preset number of discharge cycles include a first preset number of discharge cycles and a second preset number of discharge cycles performed after completing the first preset number of discharge cycles;

determining a state transition path of the sample battery's working state during each discharge process within the preset number of discharge cycles based on discharge parameters corresponding to the time series, where the state transition path includes a first state transition path of the sample battery's working state during each discharge process within the first preset number of discharge cycles and a second state transition path of the sample battery's working state during each discharge process within the second preset number of discharge cycles, and the state transition path represents a motion trajectory of the sample battery's working state during each discharge process;

determining a benchmark working-state transition path based on the first state transition path of the sample battery's working state during each discharge process within the first preset number of discharge cycles;

calculating a distance between the second state transition path of the sample battery's working state during each discharge process within the second preset number of discharge cycles and the benchmark working-state transition path to obtain multiple sample distances;

acquiring a target state-of-health (SOH) value of the sample battery during each discharge process within the second preset number of discharge cycles;

training a neural network using the sample distances as input and the corresponding target SOH values as output to obtain a battery aging assessment model;

calculating a distance between a state transition path of a to-be-predicted target battery after a discharge process and the benchmark working-state transition path to obtain a target distance; and

inputting the target distance into the battery aging assessment model to obtain an SOH value of the to-be-predicted target battery after completing a preset target number of discharge cycles.

Optionally, the step of determining the state transition path of the sample battery's working state during each discharge process within the preset number of discharge cycles based on the discharge parameters corresponding to the time series specifically includes:

segmenting the time series according to a preset rule to obtain multiple time series segments, each including voltage time series segments and current time series segments;

discretizing the time series segments to obtain multiple pieces of discrete series data that include discrete voltage series data and discrete current series data;

acquiring temperatures, states-of-charge, and discharge rates corresponding to the time series segments; and determining the first state transition path of the sample battery's working state during each discharge process within the first preset number of discharge cycles and the second state transition path of the sample battery's working state during each discharge process within the second preset number of discharge cycles based on discharge parameters corresponding to the time series segments arranged in chronological order for each discharge process, where input features of the sample battery's working state are the discharge parameters, output features of the sample battery's working state are the discrete voltage series data, and the discharge parameters include numbers, the temperatures, the states-of-charge, and the discharge rates of the time series segments, as well as the discrete current series data.

Optionally, the discretization of the time-series segments is performed using a discrete Fourier transform.

Optionally, the step of determining the benchmark working-state transition path based on the first state transition path of the sample battery's working state during each discharge process within the first preset number of discharge cycles specifically includes:

calculating a battery state transition probability of the first state transition path and determining the benchmark working-state transition path based on a maximum value of the battery state transition probability, where the benchmark working-state transition path consists of a state transition path corresponding to a maximum value of a battery state transition probability of each of the state transition paths.

Optionally, the neural network is a recurrent neural network.

Optionally, the target distance and the sample distances are calculated using a Fréchet distance formula.

Optionally, the Fréchet distance formula is as follows:

$$F(A, B) = \inf_{\alpha, \beta} \max_{i,j \in [0, N-1]} \{d(A(\alpha(i)), B(\beta(j)))\};$$

where F(A, B) represents a Fréchet distance between a state set A($\alpha$(i)) corresponding to one state transition path and a state set B($\beta$(j)) corresponding to another state transition path; d(A($\alpha$(i)), B($\beta$(j))) represents an Euclidean or cosine distance between the state set A($\alpha$(i)) corresponding to the one state transition path and the state set B($\beta$(j)) corresponding to the another state transition path; A($\alpha$(i)) represents a set composed of states $\alpha$(i) corresponding to the one state transition path; B($\beta$(j)) represents a set composed of states $\beta$(j) corresponding to the another state transition path; $\alpha$(i) represents an ith state in the state set A($\alpha$(i)) corresponding to the one state transition path; $\beta$(j) represents a jth state in the state set B($\beta$(j)) corresponding to the another state transition path; inf represents the infimum; and N represents the total number of states in a state transition path.

A computer device, including: a memory, a processor, and a computer program stored on the memory and executable on the processor, where the processor executes the computer program to implement the battery aging assessment method based on multi-source and multi-scale high-dimensional state space modeling of any one of the foregoing.

A computer-readable storage medium with a computer program stored thereon, where the computer program, when executed by a processor, implements the battery aging assessment method based on multi-source and multi-scale high-dimensional state space modeling of any one of the foregoing.

A computer program product including a computer program, where the computer program, when executed by a processor, implements the battery aging assessment method based on multi-source and multi-scale high-dimensional state space modeling of any one of the foregoing.

According to the embodiments provided by this disclosure, the following technical effects are disclosed: this disclosure can model specific states of batteries and leverage the inherent properties of fine-grained models, including invariance, timeliness, generality, and completeness. This allows modeling data from other batteries to serve as usable samples for a specific battery, thereby accelerating prediction progress and improving SOH prediction accuracy. The method can meet the requirements for battery aging assessment and prediction under various operating conditions.

BRIEF DESCRIPTION OF THE DRAWINGS

To describe the technical solutions in the embodiments of this disclosure or in the prior art more clearly, the following briefly introduces the accompanying drawings required for describing the embodiments. Apparently, the accompanying drawings in the following description show merely some embodiments of this disclosure, and a person of ordinary skill in the art may still derive other drawings from these accompanying drawings without creative efforts.

FIG. 1 is a schematic flowchart of a battery aging assessment method based on multi-source and multi-scale high-dimensional state space modeling according to Embodiment 1 of this disclosure;
FIG. 2 shows a first-order Thevenin equivalent circuit model of a battery;
FIG. 3 shows construction of fine-grained model states based on a voltage time series during a discharge process;
FIG. 4 shows a fine-grained battery model incorporating input and output physical quantities of operating conditions;
FIG. 5 shows a state transition process in a high-dimensional state space;
FIG. 6 is a step-by-step diagram of battery aging and modeling analysis;
FIG. 7 shows a structure of a recurrent neural network for SOH prediction; and
FIG. 8 shows an internal structure of a computer device.

DETAILED DESCRIPTION OF THE EMBODIMENTS

The technical solutions in the embodiments of this disclosure will be clearly and completely described below with reference to the accompanying drawings in the embodiments of the present invention. Apparently, the described embodiments are merely some rather than all of the embodiments of this disclosure. All other embodiments obtainable by a person of ordinary skill in the art based on the embodiments of this disclosure without creative efforts shall fall within the protection scope of this disclosure.

This disclosure is intended to provide a battery aging assessment method based on multi-source and multi-scale high-dimensional state space modeling, aiming to improve the accuracy of battery aging prediction.

To address the aforementioned shortcomings of existing SOX indicator systems, such as coarse granularity, lack of environmental interactivity, and limited feature dimensions, this disclosure introduces a fine-grained modeling hierarchy with a new model unit that satisfies the following requirements: invariance: the internal composition of the model unit remains unaffected by changes in external excitation factors, supporting dynamically reconfigurable assessment needs; timeliness: state changes in the model unit can map to the aging process of the battery system, enabling the description and prediction of battery phase transitions and aging progression; generality: the model unit can describe various battery types, batches, and working states, accommodating a variety of application scenarios like echelon utilization and mixed battery configurations; and completeness: the basic features of batteries are comprehensively characterized through multi-domain feature extraction, fully considering influencing factors across different scales to holistically assess battery state and performance.

By constructing a multi-source and multi-scale high-dimensional state space through this new fine-grained modeling hierarchy, the measured quantities during a period of time within a battery's discharge series are defined as input and output features. These input and output features are quantified and defined as state vectors of the battery, allowing each discharge process of the battery to be represented as a motion trajectory composed of all the state vectors in the state space. Then, the battery's SOH is assessed by analyzing changes in state transition trajectories during the discharge process.

To make the objectives, features, and advantages of this disclosure more comprehensible, the following provides a detailed explanation of this disclosure with reference to the accompanying drawings and specific implementation manners.

Embodiment 1

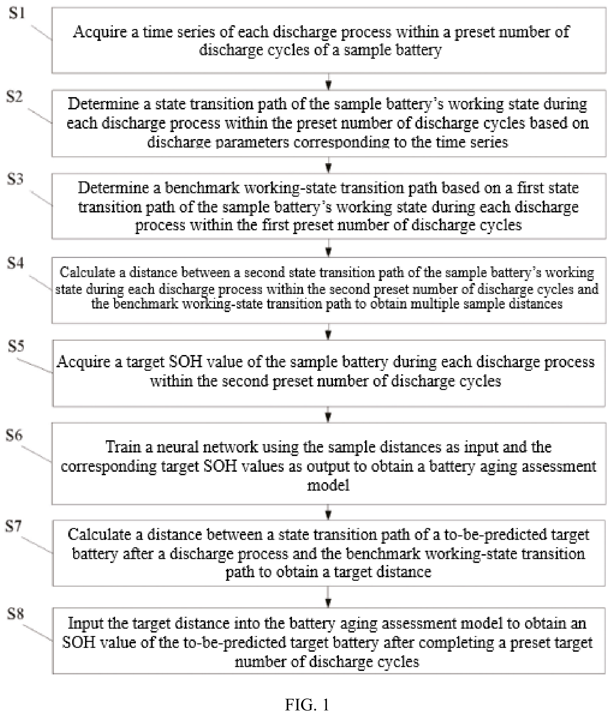

As shown in FIG. 1, this embodiment provides a battery aging assessment method based on multi-source and multi-scale high-dimensional state space modeling, including:

S101: acquiring a time series of each discharge process within a preset number of discharge cycles of a sample battery, where the time series includes a voltage time series and a current time series, and the preset number of discharge cycles include a first preset number of discharge cycles and a second preset number of discharge cycles performed after completing the first preset number of discharge cycles.

S102: determining a state transition path of the sample battery's working state during each discharge process within the preset number of discharge cycles based on discharge parameters corresponding to the time series, where the state transition path includes a first state transition path of the sample battery's working state during each discharge process within the first preset number of discharge cycles and a second state transition path of the sample battery's working state during each discharge process within the second preset number of discharge cycles, and the state transition path represents a motion trajectory of the sample battery's working state during each discharge process.

The step S102 specifically includes:

S1021: segmenting the time series according to a preset rule to obtain multiple time series segments, each including voltage time series segments and current time series segments.
S1022: discretizing the time series segments to obtain multiple pieces of discrete series data that include discrete voltage series data and discrete current series data.

In a specific implementation manner, the discretization of the time-series segments is performed using a discrete Fourier transform.
S1023: acquiring temperatures, states-of-charge, and discharge rates corresponding to the time series segments.
S1024: determining the first state transition path of the sample battery's working state during each discharge process within the first preset number of discharge cycles and the second state transition path of the sample battery's working state during each discharge process within the second preset number of discharge cycles based on discharge parameters corresponding to the time series segments arranged in chronological order for each discharge process, where input features of the sample battery's working state are the discharge parameters, output features of the sample battery's working state are the discrete voltage series data, and the discharge parameters include numbers, the temperatures, the states-of-charge, and the discharge rates of the time series segments, as well as the discrete current series data.
S103: determining a benchmark working-state transition path based on the first state transition path of the sample battery's working state during each discharge process within the first preset number of discharge cycles.
Specifically, a battery state transition probability of the first state transition path is calculated and the benchmark working-state transition path is determined based on a maximum value of the battery state transition probability, where the benchmark working-state transition path consists of a state transition path corresponding to a maximum value of a battery state transition probability of each of the state transition paths.
S104: calculating a distance between the second state transition path of the sample battery's working state during each discharge process within the second preset number of discharge cycles and the benchmark working-state transition path to obtain multiple sample distances.
In a specific implementation manner, the sample distances are calculated using a Fréchet distance formula.
S105: acquiring a target SOH value of the sample battery during each discharge process within the second preset number of discharge cycles.
S106: training a neural network using the sample distances as input and the corresponding target SOH values as output to obtain a battery aging assessment model.
In a specific implementation manner, the neural network is a recurrent neural network.
S107: calculating a distance between a state transition path of a to-be-predicted target battery after a discharge process and the benchmark working-state transition path to obtain a target distance.
In a specific implementation manner, the target distance is calculated using a Fréchet distance formula.
The Fréchet distance formula is as follows:

$$F(A, B) = \inf_{\alpha, \beta} \max_{i,j \in [0, N-1]} \{d(A(\alpha(i)), B(\beta(j)))\};$$

where d represents an Euclidean or cosine distance; $\alpha$ represents a state in a state set A corresponding to one state transition path; and $\beta$ represents a state in a state set B corresponding to another state transition path.

S108: inputting the target distance into the battery aging assessment model to obtain an SOH value of the to-be-predicted target battery after completing a preset target number of discharge cycles.

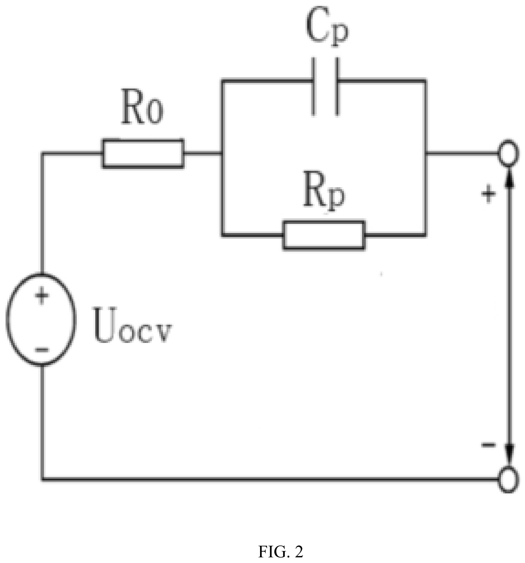

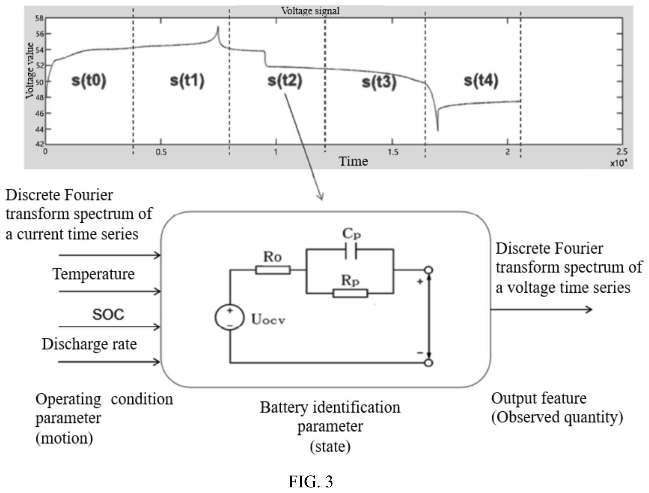

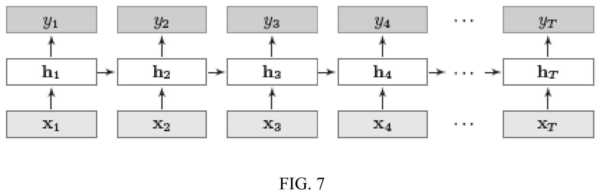

As shown in FIGs. 2-7, FIG. 2 shows a first-order Thevenin equivalent circuit model of a battery and voltage and current variations after the battery is connected to the circuit; and FIG. 3 shows a decomposition process of using discharge time series segments during a period of time within a discharge series of the battery as input data for modeling. This disclosure first segments the time series (voltage and current time series) of a discharge process of the battery in chronological order to form voltage and current time series segments as foundational modeling data. Based on these voltage and current time series, discrete Fourier transform spectrum series data of voltage and current are calculated. These data, together with the temperature, state-of-charge, and discharge rate measurements obtained during these time series segments, constitute data samples. A multi-source and multi-scale battery working state is defined according to these data samples, with input features including numbers of the time series segments, the discrete Fourier transform spectrum series of the current time series, and the temperature, state-of-charge, and discharge rate measurements, and output features including the discrete Fourier transform spectrum series of the voltage time series. The state transition probability of the battery is calculated sequentially according to the time series segments generated from the first G discharge series. Each transition from a state corresponding to one time series segment to a state corresponding to the next time series segment is calculated as one transition. By counting state transition occurrences, the transition probabilities between states are calculated to construct the dynamic process of the high-dimensional state space. Sequentially ordered by the numbers of the time series segments, a maximum transition probability from the minimum to maximum numbers of the time series segments is calculated to derive the state transition path with the highest probability, serving as a primary working path for battery state transitions. For discharge series beyond G+1 series, state transition paths corresponding to the G+1 series are generated sequentially from their time series segments, and the Fréchet distance formula is used to calculate distances between these state transition paths corresponding to the G+1 series and the primary working path. A sample set aggregating correspondences between these distances and cycle counts g (i.e., treating each distance-cycle count correspondence as one sample and aggregating multiple such correspondences to form a sample set) serves as input to the recurrent neural network; simultaneously, a sample set aggregating correspondences between remaining capacities C and cycle counts g (where the SOH is calculated as the ratio between the measured capacity after each discharge cycle and the initial rated capacity) serves as output of the recurrent neural network, thereby enabling progressive prediction of the battery's remaining capacity. Here, g represents the cycle count variable, G represents the required number of discharge series for calculating the battery state transition probability, and one discharge process is equivalent to one discharge cycle.

Step I: segment a duration T of a voltage (current) series during one battery discharge process along a time dimension into N segments, where the complete discharge series contains a total of N * p elements; the segmented voltage (current) time series segments can be numbered as $V_0, ..., V_N$ and $C_0, ..., C_N$ in chronological order, with each segment containing p elements; taking the time series segment $V_0$ as an example, it includes elements $V_{0,0}, ..., V_{0,p-1}$, and the temperatures, states-of-charge, and discharge rates corresponding to each time series segment are $TM_0, ..., TM_N$, $SOC_0, ..., SOC_N$, $D_0, ..., D_N$, respectively; and the segmentation process is shown in FIG. 2.

Step II: calculate discrete Fourier transform spectra of voltage and current time series based on the discharge time series segments, using the following formulas:

$$\overline{V}_{n,j} = \sum_{i=0}^{p-1} V_{n,i} W_p^{(i-1)(j-1)} \qquad (1)$$

$$\overline{C}_{n,j} = \sum_{i=0}^{p-1} C_{n,i} W_p^{(i-1)(j-1)} \qquad (2)$$

where $W_p = e^{(-2\pi i)/p}$ is one of p roots of 1, $n \in [0, N]$, and $i, j \in [0, p - 1]$.

Step III: define a multi-source and multi-scale battery working state $s_n$, with input features including numbers n of the time series segments, a discrete Fourier transform spectrum series of the current time series $\overline{C}_{n,0}, ..., \overline{C}_{n,qv}$ (where $q_{\overline{C}}$ << p, as the segmented series is relatively stable and primarily consists of low-frequency components, thus a value much smaller than p can be selected), a temperature series $TM_0, ..., TM_N$, a state-of-charge series $SOC_0, ..., SOC_N$, and a discharge rate series $D_0, ..., D_3$, output features including a discrete Fourier transform spectrum of the voltage time series $\overline{V}_{n,0}, ..., \overline{V}_{n,qv}$ (where $q_{\overline{V}}$ << p, as the segmented series is relatively stable and primarily consists of low-frequency components, thus a value much smaller than p can be selected):

$$s_n = [n, \overline{C}_{n,0}, \ldots, \overline{C}_{n,qv}, TM_0, \ldots, TM_N, SOC_0, \ldots, SOC_N, D_0, \ldots, D_N, \overline{V}_{n,0}, \ldots, \overline{V}_{n,qv}](3).$$

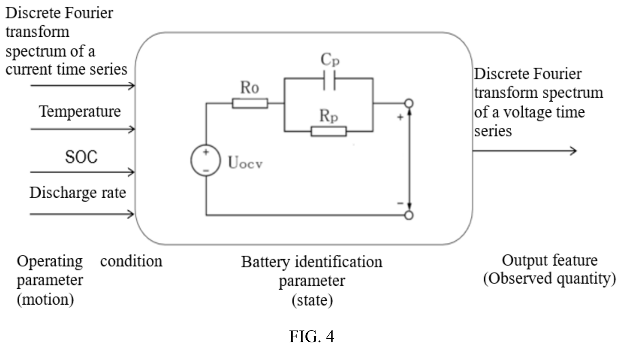

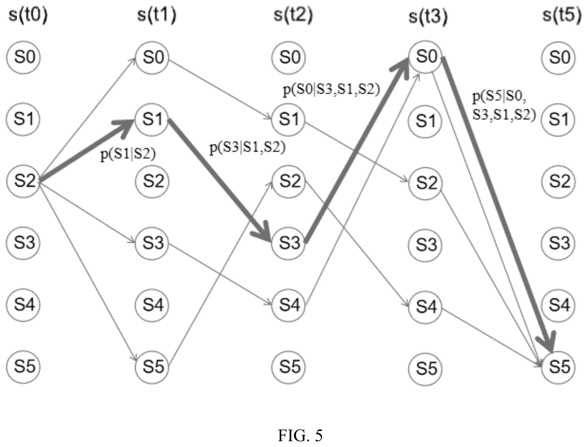

Step IV: define all states $s_{n,m}$ ($n \in [0, N]$, $m \in [0, M]$) during the battery's M discharge processes as a state space $\Phi$, where N + 1 subspaces of the state space $\Phi$ are $\Omega_n$ ($n \in [0, N]$), and $\Omega_n = \{s_{n,0}, s_{n,1}, \ldots, s_{n,M}\}$; calculate the transition probabilities of battery states $\Omega_i \rightarrow \Omega_{i+1}$ ($i \in [0, N - 1]$) to construct a dynamic process of the high-dimensional state space. FIG. 4 shows a fundamental composition of a multi-source and multi-scale fine-grained battery model incorporating operating conditions proposed by this disclosure. FIG. 5 shows a state transition process between high-dimensional state spaces constituted by the working state corresponding to the fine-grained battery model, with the thick lines representing the state transition process along the primary working path, as shown in FIGs. 4 & 5.

The transition probability from a given state $s_{i,u}$ in $\Omega_i$ to each state $s_{i+1,v}$ in $\Omega_{i+1}$ is defined as follows:

$$p(s_{i,u}, s_{i+1,v}) = \frac{\sigma(s_{i,u}, s_{i+1,v})}{\sum_{j=1}^{|\Omega_{i+1}|} \sigma(s_{i,u}, s_{i+1,j})} \qquad (4)$$

where $|\Omega_{i+1}|$ represents the total number of states in the subspace $\Omega_{i+1}$; and $\sigma(s_{i,u}, s_{i+1,v})$ represents the total number of transitions from $s_{i,u}$ to $s_{i+1,v}$ during M discharge processes (specifically, $s_{i,u}$ and $s_{i+1,v}$ are two adjacent states within the same discharge process).

Step V: calculate a state transition path satisfying a maximum probability condition given by Formula (5) as the primary working path, which can be statistically calibrated based on sample data during a period of normal system operation to serve as the initial benchmark working-state transition path of the battery. As the number of discharge cycles of the battery increases, the working-state transition path of the battery will gradually deviate from the primary working path, manifested as a continuous increase in distance relative to the primary working path, where the distance variation and the change in the battery's SOH exhibit a mapping relationship.

$$p_{max} = \max_{u \in [0, |\Omega_i|], v \in [0, |\Omega_{i+1}|]} \prod_{i=0}^{N-1} p(s_{i,u}, s_{i+1,v}) \qquad (5)$$

Step VI: for a path corresponding to $p_{max}$, with its state set being A, and another path with its state set being B, define a Fréchet distance between the two paths as follows:

$$F(A, B) = \inf_{\alpha, \beta} \max_{i,j \in [0, N-1]} \{d(A(\alpha(i)), B(\beta(j)))\} \qquad (6)$$

where d represents an Euclidean or cosine distance; and $\alpha(i)$ and $\beta(j)$ are states in A and B respectively;
Step VII: calculate a path state set $B_t$ corresponding to each number of discharge cycles t to obtain a series $F(A, Bt)$, which serves as input to a recurrent neural network; and calculate the battery's SOH value $Q_t$ obtained after each number of discharge cycles t, which serves as output of the recurrent neural network, thereby enabling progressive prediction of the battery's SOH value.

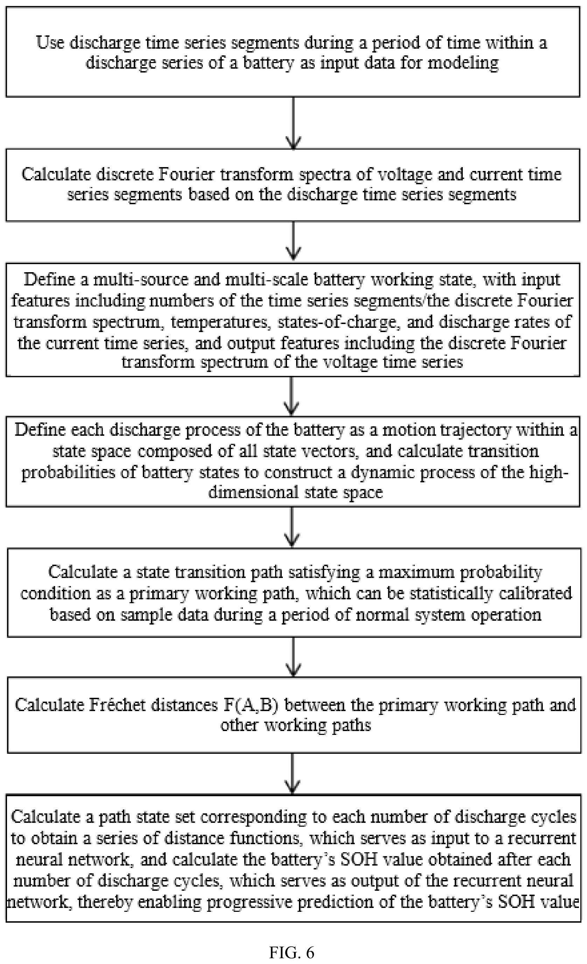

The neural network structure is shown in FIG. 6, where the input vector $X_t = F(A, Bt)$, with an encoding dimension of 1; the output vector $y_t = Qt$, with an encoding dimension of 1; and the hidden layer dimension is 20.

In a specific implementation manner, this disclosure uses sample data obtained from the first 1000 discharge cycles (the sample size of 1000 can be determined by the user, i.e., the first preset number of discharge cycles) of the sample battery to calibrate the state set A of the primary working path, and uses sample data from the 1001st to 3000th discharge cycles after 1000 discharge processes (where 3000 is determined based on actual training performance, requiring the neural network's training loss value to be below a given threshold, such as a loss threshold of 0.01, i.e., the second preset number of discharge cycles being 2000 (since 3000 - 1000 = 2000)) of the sample battery to train the recurrent neural network. After completing the neural network training (i.e., when the neural network's training loss value is below the given threshold), the SOH value of a to-be-predicted target battery can be predicted based on the series $F(A, B_t)$ as input to the neural network.

In practical applications, the trained neural network can be used for SOH prediction during battery operation: first, $X_t$ is calculated and input into the neural network model, then the predicted SOH value can be obtained as output after calculation by the neural network model.

Furthermore, in this disclosure, the sample battery includes a plurality of training batteries, where the second preset number of discharge cycles for each battery is set as required. That is to say, each training battery can yield multiple training data with different values of the second preset number of discharge cycles. The training data from the plurality of training batteries serves as the neural network's training data. For example, the training data for each training battery may include a distance between a state path obtained from each discharge process of the second preset number of discharge cycles starting from the 1001st cycle and the primary working path until reaching the 3000th cycle of the second preset number of discharge cycles, yielding 2000 pieces of training data per training battery; or, the training data may be acquired at every alternate cycle, in which case each training battery will provide 1000 pieces of training data.

This disclosure proposes a battery state modeling method that constructs a multi-source and multi-scale high-dimensional state space through a novel fine-grained modeling hierarchy, where each discharge process of the battery is defined as a motion trajectory within the state space composed of all state vectors. By analyzing variations in the battery's state transition trajectory during the discharge process, the method assesses the battery's SOH state, thereby solving problems of existing prediction algorithms, including failure to consider battery operating conditions, scarce fault samples, insufficient prediction accuracy, and poor interpretability and transferability.

Embodiment 2

A computer device, including: a memory, a processor, and a computer program stored on the memory and executable on the processor, where the processor executes the computer program to implement the battery aging assessment method based on multi-source and multi-scale high-dimensional state space modeling described in Embodiment 1.

Embodiment 3

A computer-readable storage medium with a computer program stored thereon, where the computer program, when executed by a processor, implements the battery aging assessment method based on multi-source and multi-scale high-dimensional state space modeling described in Embodiment 1.

Embodiment 4

A computer program product including a computer program, where the computer program, when executed by a processor, implements the battery aging assessment method based on multi-source and multi-scale high-dimensional state space modeling described in Embodiment 1.

Embodiment 5

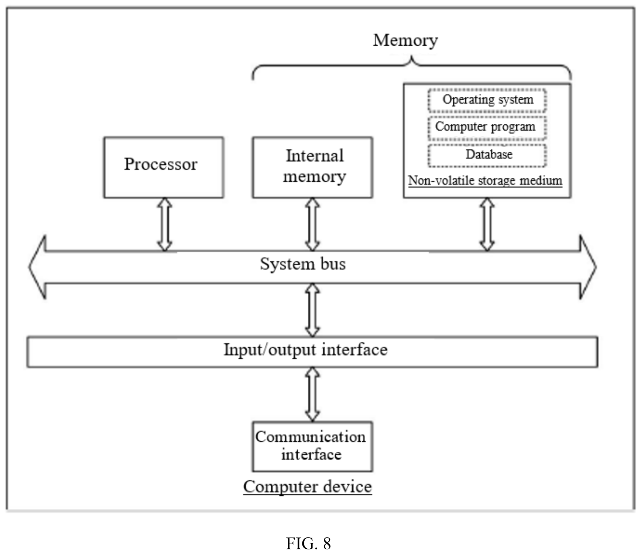

This embodiment provides a computer device, which may be a database and whose internal structure diagram may be shown in FIG. 8. The computer device includes a processor, a memory, an input/output interface (I/O), and a communication interface. The processor, memory, and input/output interface are connected via a system bus, while the communication interface is connected to the system bus through the input/output interface. The processor of the computer device is configured to provide computing and control capabilities. The memory of the computer device includes a non-volatile storage medium and an internal memory. The non-volatile storage medium stores an operating system, a computer program, and a database. The internal memory provides an environment for running the operating system and the computer program stored in the non-volatile storage medium. The database of the computer device is configured to store pending transactions. The input/output interface of the computer device is configured to exchange information between the processor and external devices. The communication interface of the computer device is configured to communicate with external terminals via network connections. The computer program, when executed by the processor, implements the battery aging assessment method based on multi-source and multi-scale high-dimensional state space modeling described in Embodiment 1.

It should be noted that all object-related information (including but not limited to object-related device information and object-related personal information) and data (including but not limited to data used for analysis, stored data, and displayed data) involved in this disclosure are authorized by the relevant objects or fully authorized by all concerned parties, and the collection, use, and processing of such data must comply with applicable laws, regulations, and standards of relevant countries and regions.

A person of ordinary skill in the art will understand that all or part of the processes in the method according to the above-described embodiments may be completed by instructing the relevant hardware through the computer program. The computer program may be stored in a non-volatile computer-readable storage medium and may include the processes mentioned in the embodiments of the above-described method when executed. Any references to the memory, database, or other media in the embodiments provided by this disclosure may include at least one of non-volatile and volatile memories. The non-volatile memory may include a read-only memory (ROM), a magnetic tape, a floppy disk, a flash memory, an optical memory, a high-density embedded non-volatile memory, a resistive random-access memory (ReRAM), a magnetoresistive random-access memory (MRAM), a ferroelectric random-access memory (FRAM), a phase-change memory (PCM), or a graphene memory. The volatile memory may include a random-access memory (RAM) or an external cache memory, among others. By way of illustration rather than limitation, the RAM may take various forms, such as a static random-access memory (SRAM) or a dynamic random-access memory (DRAM). The databases involved in the embodiments provided by this disclosure may include at least one of relational and non-relational databases. The non-relational database may include a blockchain-based distributed database, without being limited thereto. The processor involved in the embodiments provided by this disclosure may be a general-purpose processor, a central processing unit, a graphics processing unit, a digital signal processor, a programmable logic device, or a quantum computing-based data processing logic device, without being limited thereto.

The technical features of the above embodiments can be combined in any way. To simplify the description, not all possible combinations of the technical features in the above embodiments are described. However, as long as there is no contradiction in the combinations of these technical features, all possible combinations should be considered to fall within the scope of the specification.

Although the embodiments are provided to elaborate the principles and implementation manners of this disclosure, the descriptions of the aforementioned embodiments are solely intended to help understand the method and core concepts of this disclosure. Meanwhile, for a person of ordinary skill in the art, variations in specific implementation manners and application scopes may occur based on the concepts of this disclosure. In conclusion, the content of this specification should not be construed as limiting this disclosure.

## Claims

1. A battery aging assessment method based on multi-source and multi-scale high-dimensional state space modeling, comprising:

    acquiring a time series of each discharge process within a preset number of discharge cycles of a sample battery, wherein the time series comprises a voltage time series and a current time series, and the preset number of discharge cycles comprises a first preset number of discharge cycles and a second preset number of discharge cycles performed after completing the first preset number of discharge cycles;
    determining a state transition path of the sample battery's working state during each discharge process within the preset number of discharge cycles based on discharge parameters corresponding to the time series, wherein the state transition path comprises a first state transition path of the sample battery's working state during each discharge process within the first preset number of discharge cycles and a second state transition path of the sample battery's working state during each discharge process within the second preset number of discharge cycles, and the state transition path represents a motion trajectory of the sample battery's working state during each discharge process;
    determining a benchmark working-state transition path based on the first state transition path of the sample battery's working state during each discharge process within the first preset number of discharge cycles;
    calculating a distance between the second state transition path of the sample battery's working state during each discharge process within the second preset number of discharge cycles and the benchmark working-state transition path to obtain multiple sample distances;
    acquiring a target state-of-health value of the sample battery during each discharge process within the second preset number of discharge cycles;
    training a neural network using the sample distances as input and the corresponding target SOH values as output to obtain a battery aging assessment model;
    calculating a distance between a state transition path of a to-be-predicted target battery after a discharge process and the benchmark working-state transition path to obtain a target distance; and
    inputting the target distance into the battery aging assessment model to obtain a state-of-health value of the to-be-predicted target battery after completing a preset target number of discharge processes, wherein
    the step of determining the state transition path of the sample battery's working state during each discharge process within the preset number of discharge cycles based on the discharge parameters corresponding to the time series specifically comprises:

        segmenting the time series according to a preset rule to obtain multiple time series segments, each comprising voltage time series segments and current time series segments;
        discretizing the time series segments to obtain multiple pieces of discrete series data that comprise discrete voltage series data and discrete current series data;
        acquiring temperatures, states-of-charge, and discharge rates corresponding to the time series segments; and

determining the first state transition path of the sample battery's working state during each discharge process within the first preset number of discharge cycles and the second state transition path of the sample battery's working state during each discharge process within the second preset number of discharge cycles based on discharge parameters corresponding to the time series segments arranged in chronological order for each discharge process, wherein input features of the sample battery's working state are the discharge parameters, output features of the sample battery's working state are the discrete voltage series data, and the discharge parameters comprise numbers, the temperatures, the states-of-charge, and the discharge rates of the time series segments, as well as the discrete current series data;

the step of determining the benchmark working-state transition path based on the first state transition path of the sample battery's working state during each discharge process within the first preset number of discharge cycles specifically comprises:

calculating a battery state transition probability of the first state transition path and determining the benchmark working-state transition path based on a maximum value of the battery state transition probability, wherein the benchmark working-state transition path consists of a state transition path corresponding to a maximum value of a battery state transition probability of each of the state transition paths.

2. The battery aging assessment method based on multi-source and multi-scale high-dimensional state space modeling of claim 1, wherein the discretization of the time series segments is performed using a discrete Fourier transform.

3. The battery aging assessment method based on multi-source and multi-scale high-dimensional state space modeling of claim 1, wherein the neural network is a recurrent neural network.

4. The battery aging assessment method based on multi-source and multi-scale high-dimensional state space modeling of claim 1, wherein the target distance and the sample distances are calculated using a Fréchet distance formula.

5. The battery aging assessment method based on multi-source and multi-scale high-dimensional state space modeling of claim 4, wherein the Fréchet distance formula is as follows:

$$F(A, B) = \inf_{\alpha, \beta} \max_{i, j \in [0, N-1]} \{d(A(\alpha(i)), B(\beta(j)))\};$$

wherein F(A, B) represents a Fréchet distance between a state set $A(\alpha(i))$ corresponding to one state transition path and a state set $B(\beta(j))$ corresponding to another state transition path; $d(A(\alpha(i)), B(\beta(j)))$ represents an Euclidean or cosine distance between the state set $A(\alpha(i))$ corresponding to the one state transition path and the state set $B(\beta(j))$ corresponding to the another state transition path; $A(\alpha(i))$ represents a set composed of states $\alpha(i)$ corresponding to the one state transition path; $B(\beta(j))$ represents a set composed of states $\beta(j)$ corresponding to the another state transition path; $\alpha(i)$ represents an $i^{th}$ state in the state set $A(\alpha(i))$ corresponding to the one state transition path; $\beta(j)$ represents a $j^{th}$ state in the state set $B(\beta(j))$ corresponding to the another state transition path; inf represents the infimum; and N represents the total number of states in a state transition path.

6. A computer device, comprising: a memory, a processor, and a computer program stored on the memory and executable on the processor, wherein the processor executes the computer program to implement the battery aging assessment method based on multi-source and multi-scale high-dimensional state space modeling of any one of claims 1-5.

7. A computer-readable storage medium with a computer program stored thereon, wherein the computer program, when executed by a processor, implements the battery aging assessment method based on multi-source and multi-scale high-dimensional state space modeling of any one of claims 1-5.

8. A computer program product comprising a computer program, wherein the computer program, when executed by a processor, implements the battery aging assessment method based on multi-source and multi-scale high-dimensional state space modeling of any one of claims 1-5.

S1 — Acquire a time series of each discharge process within a preset number of discharge cycles of a sample battery

S2 — Determine a state transition path of the sample battery's working state during each discharge process within the preset number of discharge cycles based on discharge parameters corresponding to the time series

S3 — Determine a benchmark working-state transition path based on a first state transition path of the sample battery's working state during each discharge process within the first preset number of discharge cycles

S4 — Calculate a distance between a second state transition path of the sample battery's working state during each discharge process within the second preset number of discharge cycles and the benchmark working-state transition path to obtain multiple sample distances

S5 — Acquire a target SOH value of the sample battery during each discharge process within the second preset number of discharge cycles

S6 — Train a neural network using the sample distances as input and the corresponding target SOH values as output to obtain a battery aging assessment model

S7 — Calculate a distance between a state transition path of a to-be-predicted target battery after a discharge process and the benchmark working-state transition path to obtain a target distance

S8 — Input the target distance into the battery aging assessment model to obtain an SOH value of the to-be-predicted target battery after completing a preset target number of discharge cycles

FIG. 1

FIG. 2

FIG. 3

FIG. 4

FIG. 5

Use discharge time series segments during a period of time within a discharge series of a battery as input data for modeling

↓

Calculate discrete Fourier transform spectra of voltage and current time series segments based on the discharge time series segments

↓

Define a multi-source and multi-scale battery working state, with input features including numbers of the time series segments/the discrete Fourier transform spectrum, temperatures, states-of-charge, and discharge rates of the current time series, and output features including the discrete Fourier transform spectrum of the voltage time series

↓

Define each discharge process of the battery as a motion trajectory within a state space composed of all state vectors, and calculate transition probabilities of battery states to construct a dynamic process of the high-dimensional state space

↓

Calculate a state transition path satisfying a maximum probability condition as a primary working path, which can be statistically calibrated based on sample data during a period of normal system operation

↓

Calculate Fréchet distances F(A,B) between the primary working path and other working paths

↓

Calculate a path state set corresponding to each number of discharge cycles to obtain a series of distance functions, which serves as input to a recurrent neural network, and calculate the battery's SOH value obtained after each number of discharge cycles, which serves as output of the recurrent neural network, thereby enabling progressive prediction of the battery's SOH value

FIG. 6

FIG. 7

FIG. 8

## INTERNATIONAL SEARCH REPORT

| International application No. |
|---|
| **PCT/CN2025/092014** |

### A. CLASSIFICATION OF SUBJECT MATTER

G01R31/367(2019.01)i; G01R31/392(2019.01)i; G01R31/382(2019.01)i

According to International Patent Classification (IPC) or to both national classification and IPC

### B. FIELDS SEARCHED

Minimum documentation searched (classification system followed by classification symbols)

IPC:G01R31/-

Documentation searched other than minimum documentation to the extent that such documents are included in the fields searched

Electronic data base consulted during the international search (name of data base and, where practicable, search terms used)

CNTXT, CJFD, ENTXT, ENTXTC, VEN, CNKI, 万方, WANFANG, Bing, 百度, BAIDU, IEEE, SCI: 云储新能源, 慈松, 张明, 清华大学, 电池, 退化, 老化, 相变, 健康状态, 放电, 迁移路径, 迁移轨迹, 运动轨迹, 运动路径, 状态空间, 距离, 细粒度, 神经网络, 多源, 多尺度, CNN, RNN, SOH, battery, distance, migration, path, space, state, transition, frechet, evaluation, multi-soure, multi-scale.

### C. DOCUMENTS CONSIDERED TO BE RELEVANT

| Category* | Citation of document, with indication, where appropriate, of the relevant passages | Relevant to claim No. |
|---|---|---|
| PX | CN 118226280 A (IBATTERYCLOUD TECHNOLOGIES CO., LTD.) 21 June 2024 (2024-06-21)<br>  claims 1-10 | 1-8 |
| A | 焦东升 等 (JIAO, Dongsheng et al.). "基于离散 Fréchet 距离的电动汽车电池健康状态诊断方法 (EV Battery SOH Diagnosis Method Based on Discrete Fréchet Distance)"<br>*电力系统保护与控制 (Power System Protection and Control)*,<br>Vol. 44, No. 12, 16 June 2016 (2016-06-16), pages 68-74<br>ISSN: 1674-3415,<br>  pages 68-74 | 1-8 |
| A | CN 107436411 A (NANJING UNIVERSITY OF AERONAUTICS AND ASTRONAUTICS) 05 December 2017 (2017-12-05)<br>  entire document | 1-8 |
| A | CN 116859247 A (HARBIN INSTITUTE OF TECHNOLOGY) 10 October 2023 (2023-10-10)<br>  entire document | 1-8 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **17 June 2025** | **18 June 2025** |

| Name and mailing address of the ISA/CN | Authorized officer |
|---|---|
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2025/092014** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 117129890 A (CHONGQING UNIVERSITY) 28 November 2023 (2023-11-28) <br> entire document | 1-8 |
| A | US 2023109031 A1 (ZITARA TECHNOLOGIES, INC.) 06 April 2023 (2023-04-06) <br> entire document | 1-8 |
| A | US 2024125855 A1 (NATIONAL INSTRUMENTS CORP.) 18 April 2024 (2024-04-18) <br> entire document | 1-8 |
| A | US 2024125865 A1 (THE TRUSTEES OF COLUMBIA UNIVERSITY IN THE CITY OF NEW YORK) 18 April 2024 (2024-04-18) <br> entire document | 1-8 |
| A | 王德顺 等 (WANG, Deshun et al.). "锂离子电池模组健康状态评估模型研究 (Research on State-of-Health Evaluation Model of Lithium Ion Battery Module)" <br> 化学工程 (Chemical Engineering), Vol. 50, No. 4, 15 April 2022 (2022-04-15), pages 68-72 <br> ISSN: 1005-9954, <br> entire document | 1-8 |

Form PCT/ISA/210 (second sheet) (July 2022)

**INTERNATIONAL SEARCH REPORT**
**Information on patent family members**

International application No.

**PCT/CN2025/092014**

| Patent document cited in search report | | | Publication date (day/month/year) | Patent family member(s) | | | Publication date (day/month/year) |
|---|---|---|---|---|---|---|---|
| CN | 118226280 | A | 21 June 2024 | CN | 118226280 | B | 30 July 2024 |
| CN | 107436411 | A | 05 December 2017 | CN | 107436411 | B | 14 June 2019 |
| CN | 116859247 | A | 10 October 2023 | CN | 116859247 | B | 14 June 2024 |
| CN | 117129890 | A | 28 November 2023 | None | | | |
| US | 2023109031 | A1 | 06 April 2023 | EP | 4413386 | A1 | 14 August 2024 |
| | | | | US | 11774504 | B2 | 03 October 2023 |
| | | | | WO | 2023059652 | A1 | 13 April 2023 |
| | | | | US | 2023393204 | A1 | 07 December 2023 |
| | | | | US | 12259437 | B2 | 25 March 2025 |
| US | 2024125855 | A1 | 18 April 2024 | WO | 2024086648 | A2 | 25 April 2024 |
| | | | | WO | 2024086648 | A3 | 08 August 2024 |
| US | 2024125865 | A1 | 18 April 2024 | None | | | |

Form PCT/ISA/210 (patent family annex) (July 2022)